## Europäisches Patentamt
## European Patent Office
## Office européen des brevets

(11) Veröffentlichungsnummer: **0 184 774**
**A2**

# (12) EUROPÄISCHE PATENTANMELDUNG

(21) Anmeldenummer: 85115469.0

(22) Anmeldetag: 05.12.85

(51) Int. Cl.⁴: **H04Q 11/04 , G11C 15/04**

(30) Priorität: 14.12.84 US 682033

(43) Veröffentlichungstag der Anmeldung:
18.06.86 Patentblatt 86/25

(84) Benannte Vertragsstaaten:
AT DE FR GB IT NL SE

(71) Anmelder: International Standard Electric Corporation
320 Park Avenue
New York New York 10022(US)

(72) Erfinder: Yudichak, Joseph Ronald
264 Opening Hill Road
Madison, CT 06443(US)
Erfinder: Toegel, Herbert Joseph
77 Cross Road
Middlebury, CT 06762(US)

(74) Vertreter: Villinger, Bernhard, Dipl.-Ing. et al
Standard Elektrik Lorenz AG Patent- und Lizenzwesen Postfach 300 929 Kurze Strasse 8
D-7000 Stuttgart 30(DE)

(54) Speicheranordnung und eine Speicheranordnung enthaltende Koppelstufe zum Herstellen von dynamisch zugeordneten Verbindungswegen.

(57) Eine Speicheranordnung wird als dynamische Raum- und Zeitkoppelstufe zwischen einer Vielzahl von Quellen und Senken verwendet. Die Speicheranordnung enthält einen Assoziativspeicherteil (CAM; 14) für Quellangaben, einen Assoziativspeicherteil (CAM; 16) für Zielangaben und einen Schreib-Lese-Speicherteil (RAM; 18) für Daten. Jede Reihe bildet ein Speicherwort (12). Zum Aufbau einer Verbindung wird in einem Speicherwort (12) eine Quelladresse und im selben Speicherwort (12) eine Zieladresse gespeichert. Zum weiterschalten von Daten wird die Quelladresse über einen Zeitmultiplex-Adressbus an den Assoziativspeicherteil (14) angelegt und damit dasjenige Speicherwort (12) adressiert, das diese Quelladresse enthält. Über einen Zeitmultiplex-Datenbus werden dann die Daten in den Schreib-Lese-Speicherteil (18) des so adressierten Wortes eingeschrieben. Auch die Zieladressen werden im Zeitmultiplex an den Assoziativspeicherteil (16) angelegt. Wenn die angelegte Adresse mit einer gespeicherten Adresse übereinstimmt, dann wird der zugehörige Schreib-Lese-Speicherteil (18) aktiviert und die Daten über den Datenbus zur adressierten Senke ausgegeben. Weiter sind Möglichkeiten vorgesehen, um den Speicherwörtern (12) dynamisch Quell- und Zielangaben zuzuordnen und Zuordnungen wieder aufzuheben, um so Verbindungswege dynamisch auf- und abzubauen.

FIG.1

Speicheranordnung und eine Speicheranordnung enthaltende Koppelstufe zum Herstellen von dynamisch zugeordneten Verbindungswegen

Die Erfindung betrifft eine Speicheranordnung nach dem Oberbegriff des Hauptanspruchs und eine Koppelstufe zum Herstellen von dynamisch zugeordneten Verbindungswegen mit einer solchen Speicheranordnung.

In modernen Nachrichten- und Datensystemen ist es erforderlich, schnell und wirkungsvoll Informationen zwischen verschiedenen Punkten des Systems zu übertragen. Solche Systeme dienen der Übertragung von Sprache, Daten oder irgendeiner anderen Art von Information zwischen einer Vielzahl von Punkten, die oft durch Ein-/Ausgänge (ports) realisiert sind. Die meisten derartigen Systeme bedürfen einer Koppeleinrichtung mit wenigstens einer Koppelstufe, um die einzelnen Punkte des Systems wahlweise miteinander verbinden zu können. Moderne Systeme müssen in der Lage sein, je nach den Erfordernissen des Systems auf Befehle des Systems hin zwischen einer Vielzahl von Ein-/Ausgängen dynamisch Verbindungswege herzustellen und wieder zu unterbrechen.

Bei Systemen, die pulscodemodulierte Informationen im Zeitmultiplex zwischen mehreren Ein-/Ausgängen übertragen, kann räumliches Koppeln zwischen den einzelnen Ein-/Ausgängen und zeitliches Koppeln zwischen den einzelnen Kanälen eines oder mehrerer Ein-/Ausgänge erforderlich sein. In einem System mit 8 Ein-/Ausgängen mit je 32 Kanälen sind je 256 Quellen und Senken, zwischen denen dynamisch Verbindungswege herzustellen sind.

Die Speicheranordnung nach der Lehre des Anspruchs 1 kann, wie die Lehre des Anspruchs 4 zeigt, als Koppelstufe dienen, die die oben genannten Anforderungen erfüllt. Weitere Ausgestaltungen der Erfindung sind den Unteransprüchen und der Beschreibung zu entnehmen.

Gemäß der Erfindung wird eine Speicheranordnung verwendet, die zwei Assoziativspeicherteile und einen Schreib-Lese-Speicherteil aufweist. In der Speicheranordnung werden Wörter gebildet, wobei jeder Assoziativspeicherteil eines Wortes eine Adresse enthält, über die zum Schreib-Lese-Speicherteil dieses Wortes zugegriffen werden kann. Jedes Wort ermöglicht einen Verbindungsweg. Die Adresse eines Punktes, der die Quelle für eine Information bildet, kann in ein Assoziativspeicherteil eingegeben werden, das dann ein Quellangabenteil darstellt, während die Adresse des Zielpunkts für diese Information in den anderen Assoziativspeicherteil eingegeben wird, das dann einen Zielangabenteil bildet. Information von der Quelle wird dann in den Schreib-Lese-Speicherteil desjenigen Wortes eingeschrieben, das im Quellangabenteil die Adresse dieser Quelle enthält. Später wird diese Information an denjenigen Zielpunkt ausgegeben, dessen Adresse im Zielangabenteil dieses Wortes enthalten ist. Die Quell- und Zielangaben in den Assoziativspeicherteilen können dynamisch eingegeben und wieder gelöscht werden, wodurch die Verbindungswege auf- und abgebaut werden.

In seiner einfachsten Form stellt die Erfindung eine Vielzahl von schaltbaren Verbindungswegen zur Verfügung, durch die zwei Punkte verbunden werden, die durch Adressen gekennzeichnet sind, die in einem Quell- und einem Zielangabenteil eingegeben sind. In seiner wirkungsvollsten Form erlaubt die Erfindung höchste Flexibilität beim dynamischen Auf- und Abbau von Verbindungswegen zwischen einer Vielzahl von Punkten.

Im folgenden wird die Erfindung anhand von Ausführungsbeispielen unter Zuhilfenahme der beiliegenden Zeichnung weiter erläutert.

Figur 1 zeigt ein funktionelles Blockschaltbild einer mittels einer erfindungsgemäßen Speicheranordnung gebildeten Koppelstufe;

Figur 2 zeigt ein detaillierteres Blockschaltbild eines Ausführungsbeispiels, das zur Verwendung in einem Vermittlungssystem geeignet ist;

Figur 3 zeigt ein schematisches Schaltbild einer Speicherzelle in einem Schreib-Lese-Speicher (RAM);

Figur 4 zeigt ein schematisches Schaltbild einer Speicher- und Vergleichs-Schaltung einer Assoziativspeicherzelle (CAM-Zelle);

Figur 5 zeigt ein detailliertes Blockschaltbild der bevorzugten Ausführungsform der vorliegenden Erfindung;

Figur 6 zeigt eine Abwandlung der in Figur 3 gezeigten Speicherzelle in einem Schreib-Lese-Speicher (RAM), nun mit zwei Wortleitungen, und

Figur 7 bis 9 zeigen Zeitdiagramme für verschiedene Betriebsarten der vorliegenden Erfindung.

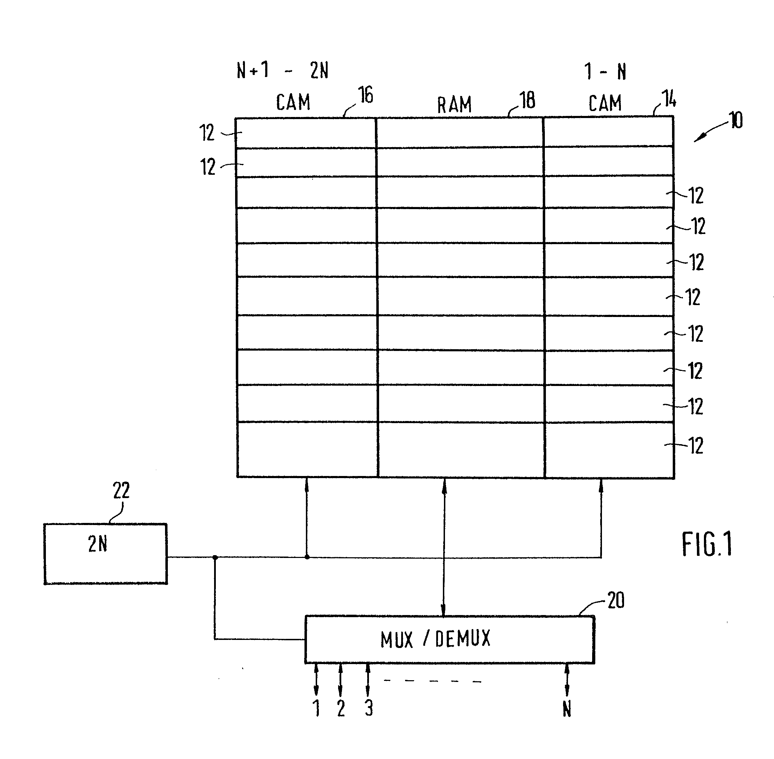

Figur 1 zeigt ein Blockschaltbild einer Koppelstufe mit einem Zuordnungsspeicher gemäß der vorliegenden Erfindung. Die Koppelstufe ist dazu bestimmt, zwischen einer Reihe von Punkten 1 bis N ausgewählte Verbindungen herzustellen Die Punkte 1 bis N sind beispielsweise Ein- und/oder Ausgänge (ports) eines die Koppelstufe enthaltenden Bausteins. Die Koppelstufe enthält einen Zuordnungsspeicher 10 mit einer Vielzahl von Speicherworten 12. Die Zahl der Speicherworte 12 ist so groß, daß sie für alle herzustellenden Verbindungen ausreicht. Der Zuordnungsspeicher 10 enthält einen Assoziativspeicherteil 14 für die Quelladresse, einen Assoziativspeicherteil 16 für die Zieladresse und einen Schreib-Lese-Speicherteil 18 für Daten. Die Assoziativspeicherteile 14 und 16 müssen pro Speicherwort 12 so viele Speicherplätze aufweisen, daß die Adressen der Punkte darin gespeichert werden können. Der Schreib-Lese-Speicherteil 18 muß pro Speicherwort 12 soviele Speicherplätze aufweisen, daß der Datenumfang abgespeichert werden kann, der jeweils beim Adressieren eines der Punkte 1 bis N anfällt. Zwischen die Punkte 1 bis N und den Schreib-Lese-Speicherteil 18 ist ein Multiplexer/Demultiplexer 20 eingefügt. Ein Zähler 22 zählt Modulo 2N und adressiert die Assoziativspeicherteile 14 und 16 und den Multiplexer/Demultiplexer 20.

Um einen ausgewählten Verbindungsweg herzustellen, wird die Adresse des Quellpunktes in den für die Quelladresse vorgesehenen Assoziativspeicherteil 14 eingegeben. Die Zählerstände 1 bis N sind den Punkten 1 bis N in ihrer Eigenschaft als Quelle zugeordnet. Denselben Punkten 1 bis N in ihrer Eigenschaft als Ziel sind die Zählerstände N + 1 bis 2N zugeordnet. Die Adresse des Zielpunktes wird in den für die Zieladresse vorgesehenen Assoziativspeicherteil 16 eingegeben und zwar in dasselbe Speicherwort 12, das auch die Quelladresse enthält.

Liegt der Zählerstand des Zählers 22 zwischen 1 und N (je einschließlich), dann wird diese Adresse in den Assoziativspeicherteil 14 für die Quelladresse eingegeben und der Multiplexer/Demultiplexer 20 schaltet vom adressierten Punkt zum Schreib-Lese-Speicherteil 18 durch. Ein Speicherwort 12, dessen Quelladressenteil mit dem Zählerstand des Zählers 22 übereinstimmt, aktiviert seinen Schreib-Lese-Speicherteil, so daß dort die über den Multiplexer/Demultiplexer 20 ankommenden Daten eingeschrieben werden. Auf diese Weise werden der Reihe nach die an den Punkten 1 bis N anliegenden Daten in den Schreib-Lese-Speicherteil 18 eingeschrieben. Liegt dann der Zählerstand des Zählers 22 zwischen N + 1 und 2N, dann wird diese Adresse in den Assoziativspeicherteil 16 für die Zieladresse eingegeben und der Multiplexer/Demultiplexer 20 schaltet vom Schreib-Lese-Speicherteil 18 zum adressierten Punkt durch. Ein Speicherwort 12, dessen Zieladressenteil dem Zählerstand des Zählers 22 entspricht, aktiviert seinen Schreib-Lese-Speicher, von dem aus die Daten über den Multiplexer/Demultiplexer 20 ausgelesen werden.

Die vorliegende Erfindung benützt damit also ausschließlich eine Speicheranordnung, nämlich den Zuordnungsspeicher 10, als Koppelstufe, mit der eine Vielzahl ausgewählter Verbindungen hergestellt werden kann. Es wird noch darauf hingewiesen, daß durch die Koppelstufe nach Figur 1 ein Quellpunkt auch mit einer Mehrzahl von Zielpunkten verbunden werden kann. Außerdem könnte ein Quellpunkt gleichzeitig Zielpunkt sein. Dadurch ergäbe sich eine Schleife mit einer Verzögerung, deren Dauer von den gewählten Kanälen abhängt.

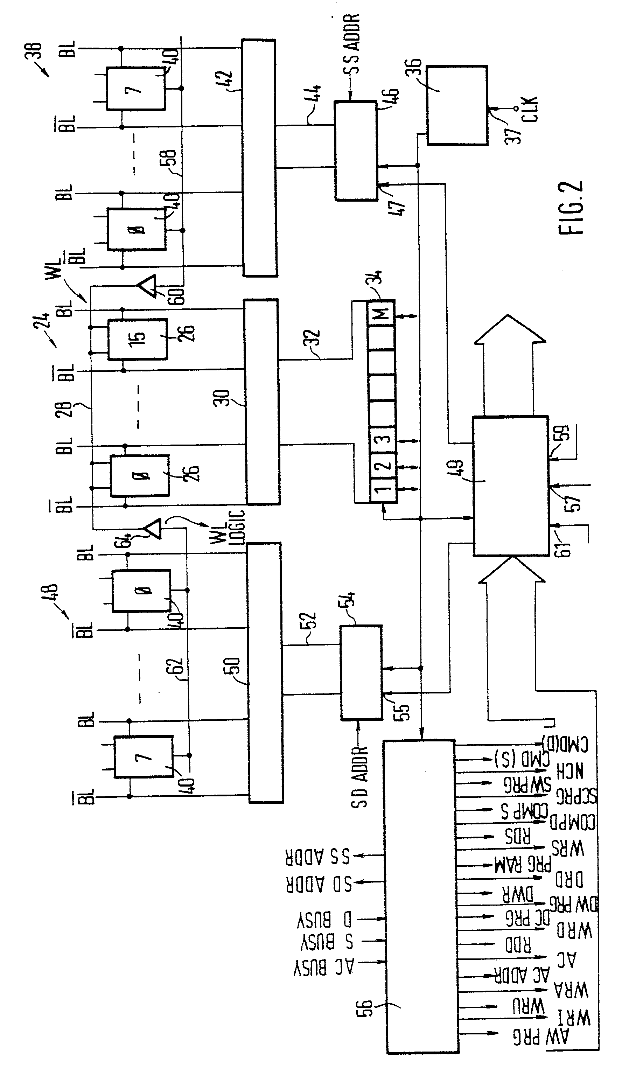

Figur 2 zeigt nun ein detailliertes Blockschaltbild eines Ausführungsbeispieles der vorliegenden Erfindung. Es ist eine Speicheranordnung vorhanden , die eine Vielzahl von Worten aufweist. Die Anzahl der Wörter muß ausreichen, um alle erforderlichen Verbindungen aufzubauen. Beim bevorzugten Ausführungsbeispiel sind dies 72 Wörter. Ein Quellangabenteil 38 und ein Zielangabenteil 48 sind für je 8 Bits ausgelegt, ein Datenteil 24 ist für 16 Bits ausgelegt. In Figur 2 sind nur die Speicherzellen eines Worts sowie Bitleitungen und eine logische Schaltung dargestellt. Die Zahl der tatsächlich vorhandenen Wörter ist beliebig, sie liegt beim bevorzugten Ausführungsbeispiel, wie schon genannt, bei 72.

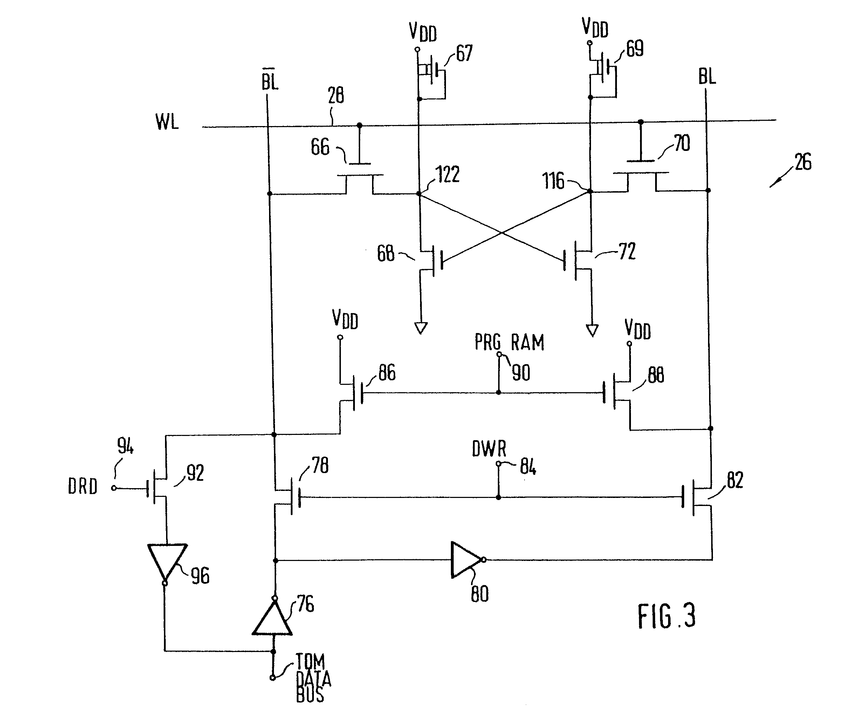

Der Datenteil 24 enthält eine Vielzahl von Speicherzellen 26, die so aufgebaut sein können, wie dies weiter unten anhand der Figur 3 beschrieben wird. Zu jedem Wort gehört eine Wortleitung 28, durch die alle Speicherzellen 26 dieses Wortes aktiviert (enable) werden können. Für jedes Bit des Datenteils 24 sind zwei Bitleitungen BL und $\overline{BL}$ vorhanden. Diese erstrecken sich über alle Wörter hinweg und sind mit allen Speicherzellen 26 einer bestimmten Bitposition verbunden. Die Bitleitungen BL und $\overline{BL}$ sind mit einer Schreib-Lese-Steuerschaltung 30 verbunden, deren Details ebenfalls anhand der Figur 3 beschrieben werden. Die Schreib-Lese-Steuerschaltung 30 wiederum ist durch einen parallelen Zeitmultiplex-Datenbus 32 wahlweise mit einer Mehrzahl von Quellen und Senken 34 verbunden.

Die Quellen und Senken 34 können in vielerlei Gestalt vorliegen, je nach dem speziellen System, in dem die Erfindung benützt werden soll. Sie werden einzeln durch ein Signal von einem Mutter-Zähler 36 angesteuert. Dieser erhält an einem Eingang 37 ein Taktsignal CLK. Das Taktsignal CLK kann aus dem benützenden System kommen. Wenn eine Quelle angesteuert wird, so gibt sie die in einem Zwischenspeicher enthaltenen Daten an den Zeitmultiplex-Datenbus 32 ab. Die Quellen und Senken 34 könnten pulscodemodulierte Signale verarbeiten, bei denen jeweils eine Mehrzahl von Kanälen in Zeitrahmen zusammengefaßt wäre. In diesem Fall wären jeder Quelle und Senke mehrere Adressen zugeordnet, und zwar jedem Kanal eine Adresse.

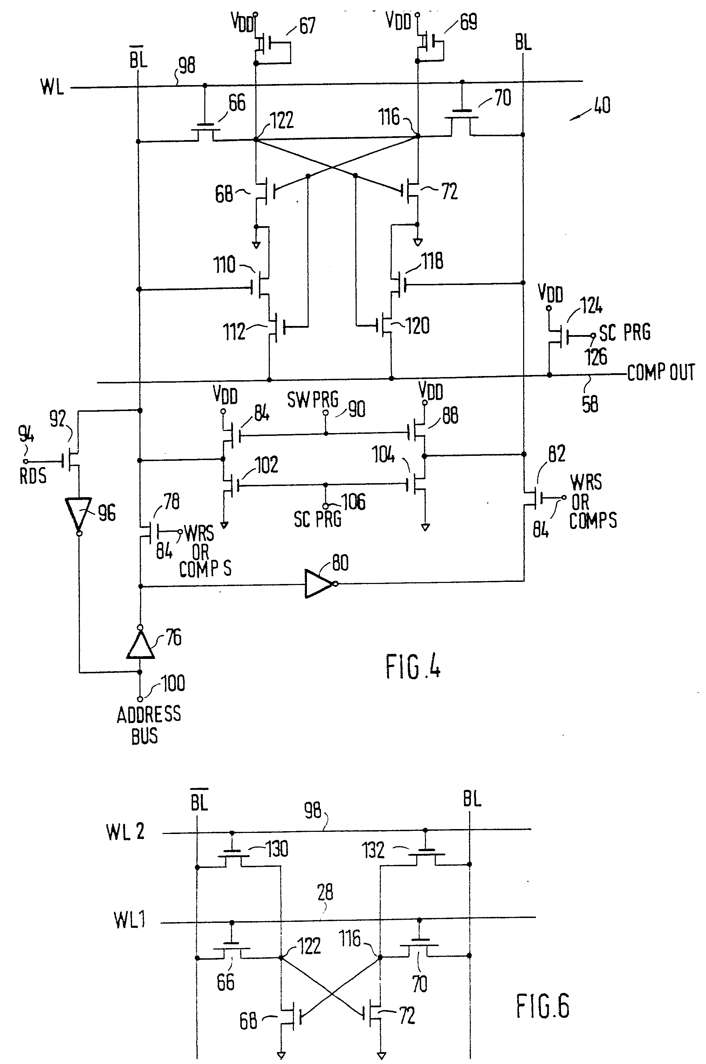

Der Quellangabenteil 38 enthält eine Vielzahl von Assoziativspeicherzellen 40. Diese werden weiter unten anhand der Figur 4 beschrieben. Der Quellangabenteil 38 enthält für jedes Wort acht Assoziativspeicherzellen zum Speichern und zum Vergleich einer Quelladresse mit acht Bit. Jede Assoziativspeicherzelle 40 ist mit zwei Bitleitungen BL und $\overline{BL}$ verbunden, die sich über alle Wörter erstrecken und die wiederum mit einer Quelladress-Steuerschaltung 42 verbunden sind, die für jedes Bitleitungspaar eine Auswahllogik enthält. Auch dies wird anhand der Figur 4 beschrieben.

Die Quelladress-Steuerschaltung 42 ist über einen Quelladress-Bus 44 mit einer Quelladress-Schaltung 46 verbunden. Die Quelladress-Schaltung 46 kann mehrere Zähler und Register zum Erzeugen und Speichern von Quelladressen aufweisen. Über einen Eingang 47 kann von einem äußeren System aus über eine Steuerschaltung 49 eine Quelladresse eingegeben werden. Die Quelladress-Schaltung 46 erhält weiter Signale vom Mutter-Zähler 36 sowie ein Quelladress-Auswahlsignal SS ADDR von einer Ablaufsteuerschaltung 56. Als Antwort auf diese Signale gibt die Quelladress-Schaltung 46 aus einem bestimmten Zähler oder Register eine Quelladresse auf den Quelladress-Bus 44 während eines bestimmten Zeitschlitzes. Die Zähler in der Quelladress-Schaltung 46 können den verschiedenen Quellen zugeordnet sein, um dynamisch sich ändernde Adressen zu erzeugen, die demjenigen Kanal entsprechen, der jeweils gerade von der Quelle kommt.

Der Zielangabenteil 48 entpricht in Aufbau und Wirkungsweise dem Quellangabenteil 38. Er enthält ebenfalls Assoziativspeicherzellen 40, die über Bitleitungen BL und $\overline{BL}$ mit einer Zieladress-Steuerschaltung 50 verbunden sind, die der Quelladress-Steuerschaltung 42 entspricht. Dem Quelladress-Bus 44 entpricht ein Zieladress-Bus 52, der Quelladress-Schaltung 46 eine Zieladress-Schaltung 54. Dem Eingang 47 entspricht ein Eingang 55, dem Quelladress-Auswahlsignal SS ADDR entspricht ein Zieladress-Auswahlsignal SD ADDR. Die Steuerschaltung 49 und die Ablaufsteuerschaltung 56 sind nur einmal vorhanden und steuern den Quellangabenteil 38. ebenso wie den Zielangabenteil 48.

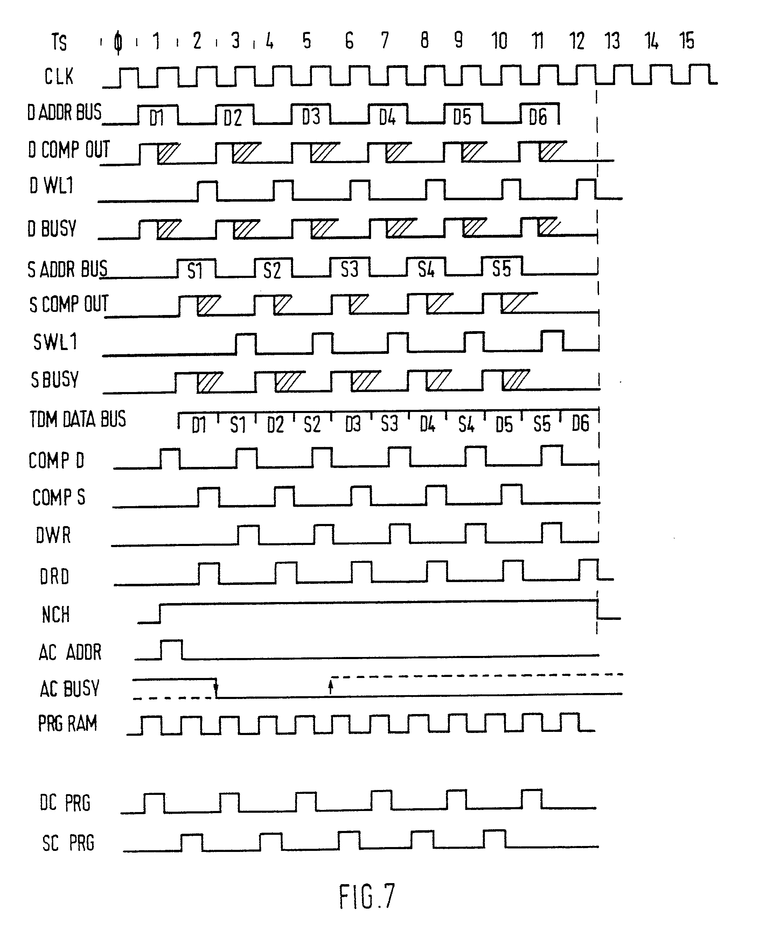

Der Mutter-Zähler 36 ist auch mit der Ablaufsteuerschaltung 56 verbunden. Diese stellt für den richtigen Betriebsablauf erforderliche zeitlich aufeinander abgestimmte Signale zur Verfügung. Diese Signale gelangen zur Steuerschaltung 49, wo sie mit Befehlen verknüpft werden, die die Steuerschaltung 49 über einen Befehlseingang 57 von außen erhält. Der Zeitablauf wird weiter unten anhand der Figuren 7 bis 9 beschrieben. Die Steuerschaltung 49 ist auch in der Lage, von außen über einen Eingang 59 Quelladressen und über einen Eingang 61 Zieladressen zu empfangen.

Der Betrieb der in Figur 3 gezeigten Koppelstufe wird beschrieben unter der Voraussetzung, daß bereits eine Anzahl von Quell- und Zieladressen in den Quell- bzw. Zielangabenteil 38 bzw. 48 eingegeben wurden, um die von der Koppelstufe miteinander zu verbindenden Quellen und Senken 34 zu kennzeichnen. Wenn an den Quelladress-Bus 44 von der Quelladress-Schaltung 46 eine Adresse angelegt wird, dann führen alle Assoziativspeicherzellen 40 des ganzen Quellangabenteils 38 einen Vergleich durch. Dies wird weiter unten im einzelnen beschrieben. Wenn jedes Bit einer für ein Wort gespeicherten Adresse mit dem entsprechenden Bit auf dem Quell-Adress-Bus 44 übereinstimmt, dann führt dies auf einer Vergleichsleitung 58 zu einem Pegel, der einer logischen 1 entspricht. Wenn sich bei einem Bit keine Übereinstimmung ergibt, dann wird dadurch die ganze Vergleichsleitung 58 auf logische 0 gesetzt.

Die Vergleichsleitung 58 ist mit der Wortleitung 28 im Datenteil 24 durch einen Trennverstärker 60 verbunden. Wenn also jedes Bit des Quelladress-Busses 44 mit einer gespeicherten Adresse im Quellangabenteil 38 übereinstimmt, dann wird die zugehörige Wortleitung 28 auf logisch 1 gesetzt. Dadurch werden alle Speicherzellen 26 dieses Worts aktiviert, nachdem die Quelladress-Schaltung 46 vom Mutter-Zähler 36 aus aktiviert wurde. Während dieses nachfolgenden Zeitabschnitts aktiviert der Mutter-Zähler 36 diejenige Quelle 34, deren Adresse der von der Quelladress-Schaltung 46 angegebenen entspricht, und veranlaßt dadurch die Quelle 34, die anstehenden Daten auf den Zeitmultiplex-Datenbus 32 durchzuschalten, so daß die parallel anstehenden Datenbits in die Speicherzellen 26 des aktivierten Worts eingeschrieben werden können.

In ähnlicher Weise wird die Zieladress-Schaltung 54 während eines passenden Zeitabschnitts vom Mutter-Zähler 36 aktiviert, bevor die adressierte Senke 34 aktiviert wird. Damit werden die Zieladress-Bits auf die Bitleitungen des Zielangabenteils 48 gegeben. Wenn die auf dem Zieladress-Bus 52 anliegende Adresse in einem Wort im Zielangabenteil 48 gespeichert ist, dann wird eine zugehörige Vergleichsleitung 62 auf logisch 1 gesetzt, wodurch über einen Trennverstärker 64 die Wortleitung 28 auf logisch 1 gesetzt wird. Dadurch werden die Speicherzellen 26 des adressierten Wortes aktiviert. Die in den aktivierten Speicherzellen 26 enthaltenen Daten werden ausgelesen und über den Zeitmultiplex-Datenbus 32 zu derjenigen Senke 34 geleitet, deren Adresse der auf dem Zieladress-Bus 52 entspricht.

Figur 3 zeigt nun ein Schaltbild einer Speicherzelle 26, wie sie im Datenteil 24 des Zuordnungsspeichers benützt wird. Die Speicherzelle 26 besteht im wesentlichen aus einem Speicherteil, der in üblicher Weise miteinander verbundene Transistoren 66, 68, 70 und 72 enthält. Die Transistoren 66, 68, 70 und 72 bilden ein dynamisches RAM; eine Auffrischungsschaltung (refresh) wäre erforderlich. Nun sind Transistoren 67 und 69 vorhanden und in üblicher Weise angeschlossen, um das RAM statisch zu machen, wodurch sich eine Auffrischungsschaltung erübrigt.

Die Transistoren 66 und 70 sind mit der Wortleitung 28 verbunden. Damit wird die Speicherzelle 26 aktiviert und mit den Bitleitungen BL und $\overline{BL}$ verbunden. Diese Bitleitungen erstrecken sich durch alle Wörter der Speicheranordnung und verbinden alle einer bestimmten Bitposition zugehörigen Speicherzellen miteinander. Die Bitleitungen sind, wie anhand der Figur 2 beschrieben, mit der Schreib-Lese-Steuerschaltung 30 verbunden, die für jedes Bitleitungspaar die in Figur 3 gezeigte Steuerlogik, die das Einschreiben und Auslesen der angeschlossenen Speicherzellen steuert.

Die Steuerlogik für jedes Bitleitungspaar enthält einen Anschlußpunkt 74 zum Anschluß an eine Leitung des parallelen Zeitmultiplex-Datenbusses 32, um vom Bus Daten zu empfangen und gespeicherte Daten an den Bus zu geben. Der Anschlußpunkt 74 ist mit dem Eingang eines Inverters 76 verbunden, dessen Ausgang über einen Transistor 78 mit der Bitleitung $\overline{BL}$ und über einen weiteren Inverter 80 und einen Transistor 82 mit der Bitleitung BL verbunden ist. Ein Eingang 84 ist zum Empfang eines Einschreibsignals DWR (data wirte) vorgesehen. Er ist mit den Transistoren 78 und 82 verbunden und ermöglicht den Datenfluß vom Zeitmultiplex-Datenbus 32 zu den Bitleitungen BL und $\overline{BL}$. Vor dem Durchführen einer Einschreib-Operation durch Anlegen des Einschreibsignals DWR an den Eingang 84 werden die Bitleitungen durch eine Vorladung vorbereitet, die durch Transistoren 86 und 88 erzeugt wird. Die Transistoren 86 und 88 werden durch ein Vorladungs-Signal PRG RAM (precharge RAM) gesteuert, das an einen Anschlußpunkt 90 angelegt wird. Dadurch werden die Transistoren 86 und 88 leitend und verbinden die Bitleitungen mit der Betriebsspannung $V_{DD}$, wodurch sie auf logisch 1 zu liegen kommen.

Nach der Vorladung wird das Einschreibsignal DWR an den Eingang 84 angelegt, wodurch die Daten vom Zeitmultiplex-Datenbus auf die Bitleitungen gelangen. Wenn die Wortleitung 28 mit logisch 1 beaufschlagt wird, werden die Transistoren 66 und 70 durchgeschaltet, wodurch die Daten auf den Bitleitungen in die Speicherzelle 26 eingeschrieben werden. Sie werden dann an zwei Knotenpunkten, 116 und 122, gespeichert.

Um ein in der Speicherzelle 26 gespeichertes Datenbit auszulesen, ist in der Schreib-Lese-Steuerschaltung 30 für jedes Bitleitungspaar ein Transistor 92 vorhanden, der mit der Bitleitung $\overline{BL}$ verbunden ist und diese mit einem Inverter 96 verbindet, wenn an einen Anschlußpunkt 94 ein Lesesignal DRD (data read) angelegt wird. Die ausgelesenen Daten werden über den Inverter 96 an den Anschlußpunkt 74 angelegt. Um die in einer Speicherzelle gespeicherten Daten auszulesen, werden die Bitleitungen BL und $\overline{BL}$ über die Transistoren 86 und 88 vorgespannt und die Wortleitung 28 wird auf logisch 1 gesetzt. Damit leiten die Transistoren 66 und 70 und übertragen die an den Knotenpunkten 116 und 122 gespeicherten Daten auf die Bitleitungen. Wird nun an den Anschlußpunkt 94 ein Lesesignal DRD angelegt und damit Transistor 92 leitend gemacht, dann wird das an der Bitleitung $\overline{BL}$ anliegende Signal über den Inverter 96 zum Anschlußpunkt 74 durchgeschaltet. Der zeitliche Ablauf dieses Vorgangs wird anhand der Figur 7 beschrieben werden.

Figur 4 zeigt den Schaltplan einer Assoziativspeicherzelle 40, die einen Schreib-Lese-Speicherteil aufweist, der dem in Figur 3 ähnlich ist und weiter einen Vergleicherteil und einen Busanschlußteil, der der Steuerlogik in Figur 3 ähnelt, jedoch zusätzlich eine Schaltung zur Entladung der Bitleitungen aufweist. Diejenigen Bauelemente der Schaltung nach Figur 4, die jenen in Figur 3 entsprechen, tragen gleiche Bezugszeichen. Die Assoziativspeicherzelle 40 in Figur 4 wird als eine solche aus dem Quellangabenteil 38 beschrieben. Die Assoziativspeicherzellen des Zielangabenteils sind gleich aufgebaut, erhalten aber andere Steuersignale mit anderem Zeitverhalten, wie anhand der Figur 7 gezeigt werden wird.

Der Schreib-Lese-Speicherteil (RAM) weist Transistoren 66, 68, 70 und 72 auf, wobei die Transistoren 66 und 70 mit einer Wortleitung 98 verbunden sind, die je nach Verwendungszweck mit der in Figur 3 gezeigten Wortleitung 28 übereinstimmt oder nicht. Die mit den Bitleitungen verbundene Steuerlogik weist einen Anschlußpunkt 100 auf, der mit einer Leitung des Quelladress-Busses 44 verbunden ist. Die Inverter 76 und 80 sowie die Transistoren 78 und 82 haben dieselbe Aufgabe wie in der Schaltung nach Figur 3. Der Eingang 84 ist hier der Einfachheit halber zweimal gezeichnet. Er empfängt ein Quell-Schreib-Signal WRS oder, wenn verglichen werden soll, ein Quell-Vergleichs-Signal COMPS. Die Transistoren 86 und 88 und der Anschlußpunkt 90 haben die gleiche Aufgabe wie in Figur 3 und werden benutzt, um die Bitleitungen so vorzuladen, daß sie auf logisch 1 liegen. Dies erfolgt durch ein Signal SWPRG, das vor einer Lese- oder Schreib-Operation angelegt wird. Die Steuerlogik enthält außerdem zwei Transistoren 102 und 104, die durch ein über einen Eingang 106 eingegebenes Signal SCPRG gesteuert werden. Dies erfolgt vor einem Vergleich. Wenn eingeschrieben werden soll, dann werden die Bitleitungen auf logisch 1 vorgeladen, während vor einem Vergleich die Bitleitungen auf logisch 0 entladen werden, indem sie über die Transistoren 102 und 104 mit Massepotential verbunden werden.

Das Auslesen erfolgt im wesentlichen wie in Figur 3. Es wird durch den Transistor 92, den Anschlußpunkt 94 und den Inverter 96 ermöglicht. Der Ausgang des Inverters 96 ist mit dem Anschlußpunkt 100 verbunden. Dort können die eingespeicherten Daten ausgelesen werden.

Der Vergleicherteil weist zwischen Masse und der Vergleichsleitung 58 in Reihe geschaltete Transistoren 110 und 112 auf. Der Transistor 110 schaltet in Abhängigkeit vom Signal auf der Bitleitung $\overline{BL}$, während der Transistor 112 vom Potential am Knotenpunkt 116 der Speicherzelle abhängt. In gleicher Weise sind zwischen Masse und Vergleichsleitung 58 zwei weitere Transistoren 118 und 120 in Reihe geschaltet. Der Transistor 118 schaltet in Abhängigkeit vom Signal auf der Bitleitung BL, während der Transistor 120 vom Potential am Knotenpunkt 112 der Speicherzelle abhängt. Zwischen die Betriebsspannung $V_{DD}$ und die Vergleichsleitung 58 ist ein Transistor 124 geschaltet, der durch das Signal SCPRG über einen Eingang 126 gesteuert wird. Damit wird vor einem Vergleich die Vergleichsleitung 58 auf logisch 1 vorgeladen. Der Transistor 124 gehört eigentlich nicht der Assoziativspeicherzelle 40 an. Er ist in Figur 4 zur einfacheren Erläuterung so eingezeichnet. Für jede der Vergleichsleileitungen 58 und 62 in Figur 2 ist ein solcher Transistor 124 erforderlich.

Der Vergleicherteil hat die Aufgabe, ein am Anschlußpunkt 100 vom Quelladress-Bus 44 vorgegebenes Bit mit dem im Schreib-Lese-Speicherteil gespeicherten, derselben Bitleitung zugeordneten Bit zu vergleichen. Vor einem Vergleich werden die Bitleitungen BL und $\overline{BL}$ durch das Siganl SCPRG am Eingang 106 auf logisch 0 entladen. Die Vergleichsleitung 58 wird durch das Signal SCPRG auf logisch 1 vorgeladen. Wenn die in Figur 4 gezeigte Assoziativspeicherzelle eine logische 1 speichert, dann ist der Knotenpunkt 116 auf logisch 1 und der Knotenpunkt 122 auf logisch 0.

Beim Empfang des Quell-Vergleichs-Signals COMP S am Eingang 84 wird eine am Anschlußpunkt·100 anstehende logische 1 als logische 1 auf die Bitleitung BL und als logische 0 auf die Bitleitung $\overline{BL}$ gegeben. Die Wortleitung 98 ist zu dieser Zeit auf logisch 0, die Transistoren 66 und 70 sperren. Durch die logische 1 auf der Bitleitung BL wird der Transistor 118 geöffnet, während der Transistor 120 durch die logische 0 am Knotenpunkt 122 gesperrt wird. Die Reihenschaltung der Transistoren 118 und 120 erscheint als offener Schalter. Durch die logische 0 auf der Bitleitung $\overline{BL}$ wird der Transistor 110 gesperrt, während der Transistor 112 durch die logische 1 am Knotenpunkt 116 geöffnet wird. Die Reihenschaltung der Transistoren 110 und 112 erscheint ebenfalls als offener Schalter. Die Vergleichsleitung 58 bleibt damit geladen, d.h. auf logisch 1. Dadurch wird angezeigt, daß die Adresse auf dem Quelladress-Buss 44 und die im Asszativspeicher an dieser Bitposition übereinstimmen.

Steht dagegen am Anschlußpunkt 100 eine logische 0 an, dann kommt die Bitleitung BL auf logisch 0 und die Bitleitung $\overline{BL}$ auf logisch 1. Der Transistor 110 wird dann durch die logische 1 auf der Bitleitung $\overline{BL}$ geöffnet, der Transistor 112 wird durch die im Knotenpunkt 116 gespeicherte logische 1 geöffnet . Dadurch wird die Vergleichsleitung 58 mit Masse verbunden, am Vergleichsausgang COMP OUT liegt logisch 0. Die Transistoren 118 und 120 bleiben gesperrt, weil auf der Bitleitung BL und am Knotenpunkt 122 logisch 0 anliegt. Eine logische 0 an der Vergleichsleitung 58 zeigt an, daß die Adresse am Quelladress-Bus nicht mit der in den Assoziativspeicherzellen übereinstimmt.

In Figur 2 ist gezeigt, wie die Vergleichsausgänge der einzelnen Assoziativspeicherzellen mit den Vergleichsleitungen 58 und 62 verbunden sind. Wenn irgendeine Assoziativspeicherzelle 40 logisch 0 angibt, dann wird damit die vorgeladene Vergleichsleitung entladen und auf logisch 0 gesetzt.

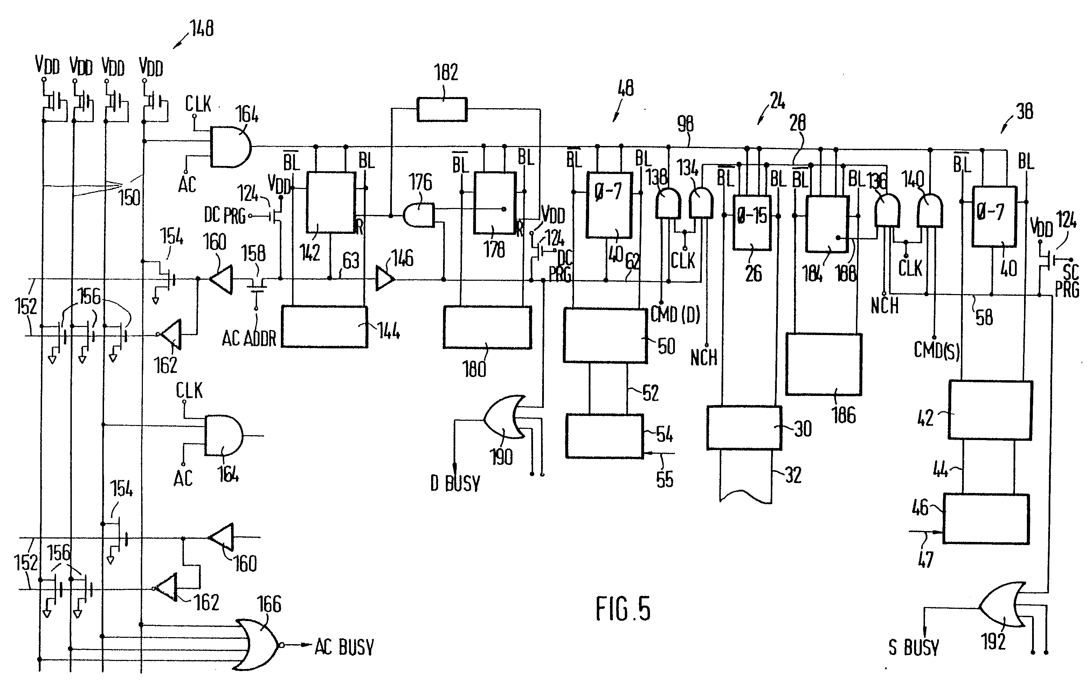

Figur 5 zeigt ein detailliertes Blockschaltbild einer bevorzugten Ausführungsform der vorliegenden Erfindung. Das Blockschaltbild der Figur 5 enthält die schon anhand der Figur 2 beschriebene Speicheranordnung. Es ist eine Anzahl von Speicherzellen 26 vorhanden, die den Datenteil 24 bilden. Darin werden die Datenbits für jedes Wort gespeichert. Die Anzahl der Bits pro Wort und die Anzahl der Wörter ist durch die Anforderungen des Systems bestimmt, das diese Speicheranordnung enthält. Bei der vorgestellten Ausführungsform werden 16 Bits pro Wort benötigt. Die Speicherzellen 26 sind, wie schon beschrieben, durch Bitleitungspaare mit der Schreib-Lese-Steuerschaltung 30 und über diese mit dem Zeitmultiplex-Datenbus 32 verbunden. Weiter sind zwei Assoziativspeicherteile vorhanden und zwar ein Quellangabeteil 38 mit Assoziativspeicherzellen 40 für Quelladressen und Zielangabeteil 48 mit Assoziativspeicherzellen 40 für Zieladressen.

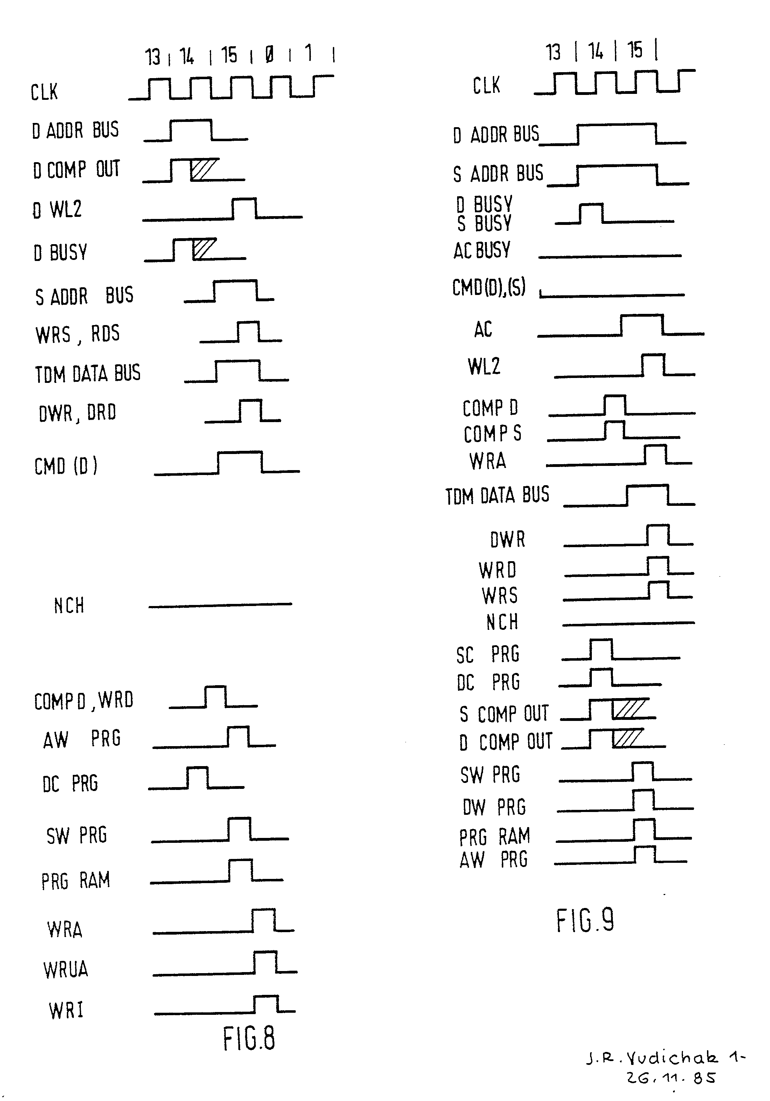

Die Zahl der Adressbits hängt von der Zahl erforderlicher Adressen ab. Bei der beschriebenen Ausführungsform sind je 8 Bits zum Speichern von Quell- und Zieladressen vorgesehen. Die Assoziativspeicherzellen sind durch Bitleitungspaare mit den Quelladress- und Zieladress-Steuerschaltungen 42 und 50 verbunden, die wiederum über die Quelladress- und Zieladress-Busse 44 und 52 mit den Quelladress- und Zieladress-Schaltungen 46 und 54 verbunden sind. Zwei Transistoren 124 sind, wie anhand der Figur 4 beschrieben, an die Vergleichsleitungen 58 und 62 angeschlossen, um diese bei einem Vergleich zum richtigen Zeitpunkt vorzuladen. Dies wird anhand der Figur 9 beschrieben werden.

Die erste Wortleitung 28 ist nur mit den Speicherzellen 26 verbunden. Sie steht mit den Vergleichsleitungen 58 und 62 in Verbindung, die das Ergebnis eines Vergleichs im Quellangabeteil bzw. im Zielangabeteil aufzeigen. Keine der Speicherzellen 26 kann anders zum Schreiben oder Lesen aktiviert werden als über einen Vergleich.

Es kann wünschenswert sein, gezielt in einem bestimmten Teil der Speicheranordnung einzuschreiben oder daraus auszulesen. Es ist deshalb eine zweite Wortleitung 98 vorgesehen, die alle Speicherzellen 26 und Assoziativspeicherzellen 40 eines Worts miteinander verbindet. Die Speicherzellen 26 müssen dann sowohl auf die Wortleitungen 28 als auch auf die Wortleitungen 98 ansprechen. Sie sind deshalb wie in Figur 6 gezeigt abgewandelt. Sie weisen zwei zusätzliche Transistoren 130 und 132 auf, deren gesteuerte Strecken denen der Transistoren 66 bzw. 70 parallelgeschaltet sind und die von der Wortleitung 98 gesteuert werden, während die Transistoren 66 und 70 von der Wortleitung 28 gesteuert werden.

Wie Figur 5 zeigt, ist zwischen die Vergleichsleitung 62 und die Wortleitung 28 ein UND-Gatter 134 und zwischen die Vergleichsleitung 58 und die Wortleitung 28 ein weiteres UND-Gatter 136 eingefügt. Je einem weiteren Eingang der UND-Gatter 134 und 136 ist ein Signal NCH zugeführt. Das Signal NCH wird auf logisch 1 gehalten, wenn im Quellangabeteil 38 oder im Zielangabeteil 48 ein Ver-

gleich stattfindet und eine logische 1 als positives Vergleichsergebnis auf die Wortleitung 28 gegeben werden könnte, um Daten vom Zeitmultiplex-Datenbus 32 in den Datenteil 24 einzuschreiben oder daraus auszulesen.

In gleicher Weise ist zwischen die Vergleichsleitung 62 und die Wortleitung 98 ein UND-Gatter 138 sowie zwischen die Vergleichsleitung 58 und die Wortleitung 98 ein UND-Gatter 140 eingefügt. Ein Signal CMD(S) ist an einen weiteren Eingang des UND-Gatters 140 angelegt; ein Signal CMD(D) ist an einen weiteren Eingang des UND-Gatters 138 angelegt.

Zur Aktivierung der UND-Gatter 134, 136, 138 und 140 ist an je einen weiteren Eingang ein Taktsignal CLK angelegt.

Wenn also in irgendein Teil eines Wortes eingeschrieben oder daraus ausgelesen werden soll, ohne einen Datentransfer zwischen den Quellen und Senken 34 auszulösen, dann wird die Wortleitung 28 gesperrt (inhibit) indem das Signal NCH auf logisch 0 gesetzt und damit die UND-Gatter 134 und 136 gesperrt werden. Jedes beliebige Wort kann entweder vom Quellangabenteil 38 oder vom Zielangabenteil 48 aus adressiert werden, indem die Adresse dieses Wortes auf den Quelladress-Bus 44 oder den Zieladress-Bus 52 gegeben wird. Diese Adresse wird dann auf die Bitleitungen des Quellangabenteils 38 oder des Zielangabenteils 48 gegeben. Wenn diese Adresse mit einer gespeicherten Adresse übereinstimmt, dann liefert die Vergleichsleitung 58 oder 62 eine logische 1 an das UND-Gatter 140 oder 138. Durch ein Signal CMD(S) oder CMD(D) an das zugeordnete Gatter wird diese logische 1 an die Wortleitung 98 weitergegeben, wodurch alle Zellen dieses Worts, sowohl Speicherzellen (RAM), als auch Assoziativspeicherzellen (CAM), aktiviert werden. Ein Einschreiben oder Auslesen von Daten in oder aus einem der Speicherteile des Worts kann dann erfolgen, wenn ein entsprechendes Signal, z.B. DWR, DRD, WRS, RDS, an den Steuerteil angelegt wird, der mit den Bitleitungen des betroffenen Speicherteils verbunden ist. Die Adresse für dieses gezielte Lesen oder Schreiben kommt von der Quelladress-Schaltung 46 oder der Zieladress-Schaltung 54. Sie kann dort von einem Zähler erzeugt oder in einem Register gespeichert sein. Die in Registern enthaltenen Adressen können von einem vorausgegangenen Lesevorgang stammen oder über die Eingänge 47 und 55 von außen eingegeben worden sein.

Es wurde nun beschrieben, wie Daten in den Datenteil 24 eingeschrieben und daraus ausgelesen werden, um so Daten zwischen einer Quelle und einer Senke zu vermitteln. Es wurde auch beschrieben, wie Adressen in den Quellangabenteil 38 und den Zielangabenteil 48 eingeschrieben oder daraus ausgelesen werden können. Es kann nun die Möglichkeit gewünscht werden, in dasjenige unbenutzte Speicherwort mit der höchsten Priorität Daten (einschließlich Adressen) eingeben zu können. Dies wird dadurch erreicht, daß eine Zuordnungs-Bitleitung und pro Wort eine Zuordnungszelle 142 verwendet wird. Die Zuordnungszellen 142 sind in gleicher Weise wie die anhand der Figur 4 beschriebenen Assoziativspeicherzellen 40 aufgebaut. Es wird jedoch eine andere Zuordnungs-Steuerlogik 144 verwendet, auch ist eine Rücksetzmöglichkeit vorgesehen. Ein Transistor 124 ist mit einer Vergleichsleitung 63 der Zuordnungszelle 142 verbunden, um, durch ein Signal DC PRG gesteuert, die Vergleichsleitung 63 vorzuladen. Die Schaltung der Zuordnungszelle 142 und der Zuordnungs-Steuerlogik 144 wird im folgenden beschrieben.

Eine Zuordnungszelle 142 speichert eine logische 1, wenn das zugeordnete Wort benutzt oder einer Verbindung zugeordnet ist. Immer, wenn im Zielangabenteil 48 ein Vergleich stattfindet, findet auch in der Zuordnungszelle 142 ein Vergleich, und zwar mit logisch 1, statt. Wenn die Zuordnungszelle 142 eine logische 0 enthält, wird die Vergleichsleitung 62 auf logisch 0 gebracht. Dadurch wird verhindert, daß die Wortleitung 28 oder 98 und damit die daran angeschlossenen Speicherzellen aktiviert werden. Die Vergleichsleitung 63 zeigt damit an, daß dieses Wort nicht benutzt ist, obwohl von einer früheren Benutzung her noch eine Adresse im Zielangabenteil 48 gespeichert ist. Die Vergleichsleitung 63 der Zuordnungszelle 142 wird auch noch in Zusammenhang mit einer Prioritätsschaltung 148 benötigt, die dasjenige freie Wort mit der höchsten Priorität kenntlich macht. Die Prioritätsschaltung 148 kann auf verschiedene Weise realisiert werden. Außer der in Figur 5 gezeigten Realisierungsmöglichkeit kann beispielsweise eine Aneinanderreihung von Gattern verwendet werden, mit der das Wort mit der höchsten Priorität ängezeigt wird, das frei und verfügbar ist. Alle Wörter mit geringerer Priorität sind der Benutzung entzogen, bis alle Wörter mit höherer Priorität benutzt sind. Die Prioritätsschaltung 148 ist im wesentlichen ein Feld von Zeilen 152 und Spalten 150, wobei jedem Wort eine Zeile und eine Spalte zugeordnet ist. Jede Spalte 150 ist mit der Betriebsspannung $V_{DD}$ verbunden, wodurch eine logische 1 erreicht wird. Jede Reihe enthält einen Transistor 154, der die dieser Reihe zugeordnete Spalte mit Masse verbinden kann und für jede Spalte eines Worts mit niedrigerer Priorität einen Transistor 156, mit dem die jeweilige Spalte mit Masse verbunden werden kann. Die Vergleichsleitung 63 der Zuordnungszelle 142 ist über einen Transistor 158 mit einem Trennverstärker 160 verbunden, der den jeweiligen Transistor 154 steuert. Der Transistor 158 wird von einem Signal ALADDR gesteuert. Der Ausgang des Trennverstärkers steuert weiter über einen Inverter 162 die Transistoren 156. Jedem Wort ist ein UND-Gatter 164 zugeordnet, das über einen Eingang mit der diesem Wort zugeordneten Spalte, über einen zweiten Eingang·mit einem Steuersignal AC und über einen dritten Eingang mit dem Taktsignal CLK verbunden ist. Der Ausgang des UND-Gatters 164 ist mit der Wortleitung 98 verbunden.

Wenn die Zuordnungszelle 142 des Worts mit der höchsten Priorität durch eine logische 0 anzeigt , daß dieses Wort gegenwärtig frei ist, dann wird die logische 0 über den Transistor 158 und den Trennverstärker 160 zum Transistor 154 übertragen, der dadurch sperrt und die logische 1 auf der zugehörigen Spalte nicht beeinflußt. Die logische 1 auf dieser Spalte gelangt an das UND-Gatter 164 des Worts mit der höchsten Priorität und wird von dort, wenn gleichzeitig das Steuersignal AC und das Taktsignal CLK auf logisch 1 liegen, an die Wortleitung 98 weitergegeben, wodurch das Einschreiben neuer Daten möglich ist. Die logische 0 am Ausgang des Trennverstärkers 160 steuert über den Inverter 162 die Transistoren 156 in den leitenden Zustand, wodurch die den Wörtern mit niedrigerer Priorität zugeordneten Spalten auf logisch 0 gelangen und damit anzeigen, daß die entsprechenden Wörter nicht verfügbar sind.

Wenn dagegen die Zuordnungszelle 142 eine logische 1 anzeigt, was bedeutet, daß das zugehörige Wort nicht verfügbar ist, dann wird der Transistor 154 leitend gesteuert und die diesem Wort zugeordnete Spalte wird auf logisch 0 gesetzt. Das UND-Gatter 164 wird dadurch gesperrt und kann die Wortleitung 98 für dieses Wort nicht mehr aktivieren. Die Spalten für die Wörter mit geringerer Priorität werden nicht beeinflußt und bleiben auf logisch 1, da die Transistoren 156 in diesem Fall sperren. Die Zuordnungszellen der Wörter mit niedrigerer Priorität können aber auf diese Spalten noch Einfluß nehmen.

Alle Spalten 150 sind mit den Eingängen eines NOR-Gatters 166 verbunden. Wenn irgendeine Spalte auf logisch 1 bleibt und damit anzeigt, daß noch ein Wort frei ist, dann ist der Ausgang des NOR-Gatters 166 auf logisch 0. Das sich ergebende Signal AC BUSY zeigt also an, ob noch ein Wort frei ist oder nicht. Nur wenn kein Wort mehr frei ist, geht das Signal AC BUSY auf logisch 1.

Wenn also das Signal AC BUSY auf logisch 0 liegt, ist noch ein Wort frei und das Steuersignal AC kann auf logisch 1 gesetzt werden, so daß über das UND-Gatter 164 des prioritätshöchsten freien Worts dessen Wortleitung 98 aktiviert werden kann. Dadurch können Daten (einschließlich Adressen) in den Datenteil 24, den Quellangabenteil 38, den Zielangabenteil 48 und die Zuordnungszelle 142 dieses Worts eingeschrieben werden. In die Zuordnungszelle 142 wird dabei immer eine logische 1 eingeschrieben, wodurch angezeigt wird, daß dieses Wort nun nicht mehr frei ist.

Die einer Assoziativspeicherzelle ähnliche Zuordnungszelle 142 enthält den Schreib-Lese-Speicherteil und den Vergleicherteil wie in Figur 4 und arbeitet wie anhand der Figur 4 beschrieben. Die Zuordnungs-Steuerlogik 144 kann die Bitleitungen durch ein Signal AW PRG vorladen oder durch ein Signal DC PRG entladen. Die Inverter 76, 80 und 96 und der Transistor 92 nach Figur 4 werden hier nicht verwendet. Über den Transistor 78 ist die Bitleitung $\overline{BL}$ mit Masse verbunden und über den Transistor 82 die Bitleitung BL mit der Betriebsspannung $V_{DD}$. Die Transistoren 78 und 82 werden durch ein Signal WRA oder COMPD angesteuert. Zum Rücksetzen der Zuordnungszelle ist der Knotenpunkt 122 über einen Transistor mit der Betriebsspannung $V_{DD}$ und der Knotenpunkt 116 über einen Transistor mit Masse verbunden. Beide Transistoren werden vom Ausgang eines UND-Gatters 176 angesteuert, das in Figur 5 gezeigt und das mit einer Rücksetzeinrichtung verbunden ist.

Es muß dafür gesorgt werden, daß ein Wort durch Rücksetzen der Zuordnungszelle wieder als frei gekennzeichnet werden kann. Am einfachsten könnte dies dadurch erfolgen, daß eine logische 0 in die Zuordnungszelle eingeschrieben würde, wozu eine geringfügige Änderung der Zuordnungs-Steuerlogik 144 erforderlich wäre. Es ist jedoch vorteilhaft, wenn die Rückstellung nur dann möglich ist, wenn im Zielangabenteil 48 gerade kein Vergleich erfolgt und keine Daten aus dem Datenteil 24 ausgelesen werden können. Dies wird durch ein weiteres Bitleitungspaar und eine Rückstellzelle 178 für jedes Wort erreicht.

Die Rückstellzelle 178 ist ähnlich wie die anhand der Figur 3 beschriebene Speicherzelle 26 aufgebaut. Die Inverter 76, 80 und 96 und der Transistor 92 fehlen jedoch. Transistor 78 ist mit Masse und Transistor 82 mit der Betriebsspannung $V_{DD}$ verbunden, beide werden durch ein Signal WR VA gesteuert. Am Anschlußpunkt 90 liegt das Vorladungs-Signal PRG RAM zum Vorladen der Bitleitungen vor dem Lesen oder Schreiben an. Zum Rücksetzen ist die Rückstellzelle 178 mit zwei zusätzlichen Transistoren versehen, von denen der eine den Knotenpunkt 122 mit der Betriebsspannung $V_{DD}$ und der andere den Knotenpunkt 116 mit Masse verbindet und die beide von einem Rücksetzsignal gesteuert werden.

Ein weiterer Ausgang der Rückstellzelle 178 verbindet den Knotenpunkt 116 mit einem Eingang des UND-Gatters 176, wie in Figur 5 gezeigt. Ein zweiter Eingang des UND-Gatters 176 ist mit der Vergleichsleitung 62 des Zielangabenteils 48 verbunden.

Um ein Wort wieder als frei zu kennzeichnen, wird in dessen Zuordnungszelle 142 mittels einer Rückstellschaltung 180 eine logische 1 eingeschrieben. Nachdem in die Rückstellzelle 178 eine logische 1 eingeschrieben ist, wird dem UND-Gatter 176 vom Knotenpunkt 116 der Rückstellzelle 178 eine logische 1 angeboten. Beim nächsten Vergleich im Zielangabenteil 48 liegt dessen Vergleichsleitung 62 auf logisch 1 und ermöglicht das Auslesen von Daten aus dem Datenteil 24. Gleichzeitig wird auch an den anderen Eingang des UND-Gatters 176 eine logische 1 angelegt. Vom Ausgang des UND-Gatters 176 wird damit eine logische 1 an die Zuordnungszelle 142 angelegt, wodurch diese auf logisch 0 gesetzt wird und so anzeigt, daß das zugehörige Wort frei ist. Der Ausgang des UND-Gatters 176 ist gleichzeitig über ein Verzögerungsglied 182 an den Rücksetzeingang der Rückstellzelle 178 geführt. Dadurch wird auch die Rückstellzelle 178 auf logisch 0 zurückgesetzt.

Es muß auch verhindert werden, daß im Quellangabenteil 38 eines unbenutzten Worts auf die Vergleichsleitung 58 beim Vergleich eine logische 1 gegeben wird. Hierfür gibt es verschiedene Möglichkeiten. Dazu könnte eine der Zuordnungszelle 142 ähnliche Anordnung im Quellangabenteil 38 vorhanden sein, die auf logisch 0 zu setzen wäre, wenn das Wort frei ist. Auf dieser Seite ist es jedoch nicht erforderlich, Maßnahmen zur Prioritätsermittlung zu ergreifen. Dies erfolgt bereits im Zielangabenteil 48. Im Quellangabenteil 38 wird deshalb einfach eine unbenutzte Adresse in ein freies Wort eingeschrieben.

Unter bestimmten Umständen ist es möglich, daß in den Datenteil 24 Daten eingeschrieben werden, wenn im Quelloder Zielangabenteil 38 bzw. 48 Adressen eingegeben werden. Es ist deshalb wünschenswert, daß beim ersten Vergleich im Quellangabenteil 38 verhindert wird, daß die am Zeitmultiplex-Datenbus 32 anliegenden Daten in den Datenteil 24 eingeschrieben werden. Ein Einschreiben darf erst erfolgen, wenn erstmals im Zielangabenteil 48 ein Vergleich stattgefunden hat und das daraus resultierende Auslesen aus dem Datenteil 24 beendet ist. Dies kann erreicht werden, indem im Datenteil 24 ein weiteres Bitleitungspaar und pro Wort eine Sperrzelle 184 sowie eine Schreib-Lese-Logikschaltung 186 hinzugefügt wird. Die Sperrzelle 184 ist eine gewöhnliche Schreib-Lese-Speicherzelle mit zwei Wortleitungen, wie sei anhand der Figur 6 beschrieben wurde. Zusätzlich weist jede Zelle vom Knotenpunkt 122 aus einen Ausgang 188 auf. Der Ausgang 188 ist mit einem weiteren Eingang des UND-Gatters 136 verbunden. Die Schreib-Sperr-Logikschaltung 186 ist ähnlich der Rückstellschaltung 180 aufgebaut. Als Schreibbefehl dient ein Signal WRI.

Wird ein Wort zunächst durch die Zuordnungszelle 142 einer Verbindung zugeordnet, dann wird die Sperrzelle 184 auf logisch 1 gesetzt. Der Knotenpunkt 122 der Sperrzelle 184 ist damit auf logisch 0. Über den Ausgang 188 wird das UND-Gatter 136 gesperrt; die Wortleitung 28 kann vom Quellangabenteil 38 aus nicht aktiviert werden. Die Vergleichsleitung 58 ist durch das UND-Gatter 136 solange blockiert, bis die logische 1 aus der Sperrzelle 184 entfernt wird. Dies erfolgt, wenn die Wortleitung 28 vom Zielangabenteil 48 her auf logisch 1 gesetzt wird. Die Sperrzelle 184 kann auf logisch 0 gesetzt werden, wenn die Wortleitung 28 wie eben beschrieben aktiviert wird.

Es kann auch erforderlich sein, darauf zu achten, daß der Zielangabenteil 48 und der Quellangabenteil 38 nicht eine bestimmte Adresse mehrfach aufweisen. Dies würde dazu führen, daß zwei verschiedene Wörter gleichzeitig aktiviert werden und daß beim Auslesen die Daten verstümmelt würden. Im Falle eines Einschreibvorganges könnte zwar gleichzeitig in mehr als ein Wort eingeschrieben werden, dies könnte aber unerwünscht sein. Bevor eine neue Adresse in den Quell- oder Zielangabenteil 38 bzw. 48 eingeschrieben wird, wird geprüft, ob diese Adresse nicht schon als Quell- bzw. Zielangabe vorhanden ist. Hierzu wird das neue Wort einschließlich Quell- und Zieladresse an die Bitleitungen von Quell- und Zielangabenteil angelegt und gleichzeitig die Vergleichsleitungen 58 und 62 überwacht. Durch die Signale AC, NCH und CMD werden gleichzeitig noch die Wortleitungen gesperrt. Wenn ein Vergleich durch eine logische 1 zeigt, daß die angelegte Quell- oder Zieladresse bereits vorhanden ist, dann kann das Einschreiben unterbunden werden. Ob auf irgendeiner Vergleichsleitung eine logische 1 anliegt, wird durch zwei ODER-Gatter 190 und 192 festgestellt, die pro Wort einen Eingang aufweisen, der mit den jeweiligen Vergleichsleitungen 62 bzw. 58 verbunden ist. Das ODER-Gatter 190 gibt an seinem Ausgang ein Signal D BUSY ab, das auf logisch 1 ist, wenn irgendeine der Vergleichsleitungen 62 auf logisch 1 ist. Ebenso gibt das ODER-Gatter 192 an seinem Ausgang ein Signal S BUSY ab, das auf logisch 1 ist, wenn irgendeine der Vergleichsleitungen 58 auf logisch 1 ist. Eine logische 1 eines der beiden Signale D BUSY und S BUSY kann zum Unterbinden des Einschreibens benutzt werden.

Aus dem Beschriebenen ist ersichtlich, daß die Koppelstufe der vorliegenden Erfindung Durchschalteverbindungen herstellen kann, bei denen Daten von einer adressierten Quelle zu einem adressierten Ziel vermittelt werden. Während einer Durchschalteverbindung werden keine neuen Wörter in die Speicheranordnung eingegeben noch werden Wörter freigegeben. Ein Zeitdiagramm, das die verschiedenen in dieser Betriebsart benötigten Signale enthält, ist in Figur 7 gezeigt.

Wie Figur 7 zeigt, kann die Koppelstufe in Perioden zu je 16 Zeitschlitzen TS betrieben werden, die von 0 bis 15 numeriert sind. Die Zeitschlitze TS werden durch den Mutter-Zähler 36 bereitgestellt, der mit dem Taktsignal CLK betrieben wird. Die Anzahl der für den Betrieb erforderlichen Zeitschlitze hängt von der Anzahl der zu verbindenden Quellen und Senken ab. Das in Figur 7 gezeigte Zeitdiagramm macht den Betrieb mit fünf Quellen S1 bis S5, und sechs Senken, D1 bis D6, möglich. Es ist zu beachten, daß diese Quellen und Senken nicht notwendigerweise physikalisch vorhanden oder räumlich benachbarte Ein-/Ausgänge sein müssen. Sie können Quellen und Senken sein, die durch die zeitliche Anordnung auf einem Zeitmultiplex-Datenbus gekennzeichnet sind. Die Quellen und Senken können räumlich und zeitlich kombiniert sein, beispielsweise, wenn ein physikalischer Ein-/Ausgang Zeitmultiplexkanäle empfängt und sendet. Eine Quelle und eine Senke könnten zum gleichen pyhsikalischen Ein-/Ausgang gehören, der zeitlich auf Quelle und Senke aufgeteilt ist. Die Zeitschlitze 0 bis 15 könnten die Zeitteilung einer Kanalzeitlage sein, während welcher die Daten von und zu den räumlich benachbarten Ein-/Ausgängen auf dem Zeitmultiplex-Datenbus 32 im Zeitmultiplex übertragen werden.

Im bevorzugten Ausführungsbeispiel könnten über jeden Ein-/Ausgang eine Mehrzahl von Kanälen, z.B. 32, geführt werden, die sich periodisch wiederholen, wobei jede Wiederholung einen Zeitrahmen bildet. Die Zeitschlitze 0 bis 15 wiederholen sich innerhalb jedes Kanals, so daß jeder physikalische Ein-/Ausgang wenigstens einmal pro Kanalzeitlage bedient wird.

Wie aus Figur 7 ersichtlich ist, werden die Zeitschlitze 0 bis 12 zur Durchführung der Verbindung verwendet. Während dieser Zeitschlitze bearbeitet die Zeitstufe Durchschalteverbindungen (switch mode). Während der Zeitschlitze 13 bis 15 werden in der Zeitstufe Einstellbefehle durchgeführt, wie später noch zu zeigen ist (command mode).

In Figur 7 sind bei den Signalen D COMP OUT, D BUSY, S COMP OUT und S BUSY schraffierte Abschnitte eingezeichnet. Diese schraffierten Abschnitte zeigen an, daß der Signalpegel sich in Abhängigkeit von den herrschenden Bedingungen ändern kann oder nicht.

Beispielsweise sind die Signale D COMP OUT und S COMP OUT auf logisch 1, wenn die Signale D C PRG und S C PRG auf logisch 1 sind. Durch die Vergleichs-Signale COMP D oder COMP S wird ein Vergleich durchgeführt und je nach Vergleichsergebnis werden die Signale D COMP OUT und S COMP OUT auf logisch 0 zurückgehen oder nicht. In gleicher Weise hängen die Signale D BUSY und S BUSY von D COMP OUT bzw. S COMP OUT ab. Sie werden jedoch nur während der Zeitschlitze 13 bis 15 verwendet, während der Zeitschlitze 0 bis 12 ist ihr Zustand unerheblich.

Das Signal NCH ist von der Mitte des Zeitschlitzes 1 bis zum Ende des Zeitschlitzes 12 auf logisch 1. Dieses Signal ermöglicht Durchschalteverbindungen (switch mode).

Der erste Schritt zum Durchführen einer Verbindung besteht im Einschreiben von Daten einer Quelle in den Datenteil 24 eines Worts, das durch die im Quellangabenteil 38 gespeicherte Adresse der Quelle identifiziert wird. Hierzu wird ein Vergleich im Quellangabenteil 38 durchgeführt durch Vergleich einer am Quelladress-Bus 44 anliegenden Adresse mit allen in den Quellangabenteilen 38 der einzelnen Wörter abgespeicherten Adressen. Durch das Signal S C PRG wird in der Quelladress-Steuerschaltung 42 jede Bitleitung auf logisch 0 gesetzt. Das Signal S C PRG wird auch am Transistor 124 angelegt, wodurch die Vergleichsleitung 58 auf logisch 1 aufgeladen wird. In Figur 7 geht das Signal S COMP OUT in der ersten Hälfte des Zeitschlitzes 2 auf logisch 1. Während der zweiten Hälfte des Zeitschlitzes 2 wird an die Quelladress-Steuerleitung 42 ein Signal COMP S angelegt, wodurch die Daten vom Quelladress-Bus 44 auf die Bitleitungen übertragen werden und so einen Vergleich herbeiführen. Wenn die Adresse vom Quelladress-Bus 44 mit irgendeiner im Quellangabenteil 38 gespeicherten Adresse übereinstimmt, bleibt die Vergleichsleitung 58 dieses Worts auf logisch 1, während das Signal S COMP OUT für alle andern Wörter während des Signals COMP S auf logisch 0 geht. Bei positivem Vergleich erscheint die logische 1 auf der Vergleichsleitung 58 und wird auf das UND-Gatter 136 gegeben, vgl. Figur 5. Vom Signal NCH und von der Sperrzelle 184 wird auch je eine logische 1 an das UND-Gatter 136 gegeben. Diese Signale am UND-Gatter 136 bleiben unverändert, bis im Zeitschlitz 3 der nächste Taktimpuls erscheint, der ebenfalls an das UND-Gatter 136 gegeben wird. Dadurch wird zu diesem Zeitpunkt die Wortleitung 28 dieses Worts (Signal S WL 1 in Figur 7) logisch 1, wodurch alle Speicherzellen 28 im Datenteil 24 dieses Worts aktiviert werden. Zu diesem Zeitpunkt erscheinen die Daten derjenigen Quelle S1, deren Adresse gerade mit dem Quellangabenteil 38 verglichen wurde, auf dem Zeitmultiplex-Datenbus 32. Das Einschreibsignal DWR veranlaßt über die Schreib-Lese-Steuerschaltung 30, daß die Daten vom Datenbus 32 in die aktivierten Speicherzellen des adressierten Worts eingeschrieben werden. Bevor das Einschreibsignal DWR an die Schreib-Lese-Steuerschaltung 30 angelegt wird, werden die Bitleitungen durch das Vorladungs-Signal PRG RAM über die Schreib-Lese-Steuerschaltung 30 auf logisch 1 vorgeladen. Die an der Quelle S1 erscheinenden Daten sind nun im Datenteil 24 eines bestimmten Worts abgespeichert, das gleichzeitig die Quelladresse enthält.

Die im Datenteil 24 gespeicherten Daten werden an eine Senke ausgelesen, deren Adresse im Zielangabenteil dieses Worts gespeichert ist. Dies erfolgt, wenn eine Zieladresse, z.B. D2 im Zeitschlitz 3, auf dem Zieladress-Bus 52 erscheint. Diese Zieladresse muß mit allen im Zielangabenteil 48 gespeicherten Adressen verglichen werden. Als erstes wird hierzu das Signal D C PRG an die Zieladress-Steuerschaltung 50 angelegt, wodurch alle Bitleitungen auf logisch 0 entladen und die Vergleichsleitungen 62 jedes Worts auf logisch 1 vorgeladen werden. Dies zeigt sich in Figur 7 im Signal D COMP OUT, das während der ersten Hälfte des Zeitschlitzes 3 auf logisch 1 geht. Während der zweiten Hälfte des Zeitschlitzes 3 wird durch das Ziel-Vergleichs-Signal COMP D an der Zieladress-Steuerschaltung 50 der Vergleich ausgelöst. Als Ergebnis des Vergleichs bleibt das Signal D COMP OUT auf logisch 1, wenn der Vergleich positiv ist oder geht auf logisch 0 zurück, wenn keine Übereinstimmung besteht. Bei dem Wort, bei dem der Vergleich positiv ist, gelangt das auf logisch 1 bleibende Signal D COMP OUT zusammen mit der logischen 1 des Signals NCH an das UND-Gatter 134. Beim nächsten Taktimpuls CLK während des Zeitschlitzes 4 gibt dann das UND-Gatter 134 eine logische 1 zur Wortleitung 28 (Signal D WL1 in Figur 7). Dadurch werden die Speicherzellen 28 im Datenteil 24 des adressierten Worts aktiviert. Während dieser Zeit im Zeitschlitz 4 ist die Senke D2, wie in Figur 7 gezeigt, mit dem Zeitmultiplex-Datenbus 32 verbunden. Dadurch wird die Übergabe von Daten von einer Quelle, deren Adresse in einem bestimmten Wort angegeben ist zu einer Senke, deren Adresse im selben Wort angegeben ist, abgeschlossen.

Es wird darauf hingewiesen, daß es möglich ist, eine Quelladresse ohne Zieladresse zu verwenden und dabei Daten für eine spätere Verwendung zu speichern. In bestimmten Fällen können auch permanente Daten in einem Wort zur Ausgabe an eine Zieladresse gespeichert sein ohne daß hierfür eine Quelladresse vorhanden ist.

Es wird auch darauf hingewiesen, daß gleichzeitig mit dem Zielangabenteil 48 auch die Zuordnungszelle 142 mit logisch 1 verglichen wird, da das Signal COMP D sowohl an die Zuordnungszelle, als auch an den Zielangabenteil gelangt. Ist die Zuordnungszelle auf logisch 0, dann findet kein Vergleich statt und die Vergleichsleitung 63 der Zuordnungszelle 142 geht während des Signals COMP D auf logisch 0 zurück. Das Signal auf der Vergleichsleitung 63 der Zuordnungszelle 142 wird in der Prioritätsschaltung 148 ausgewertet. Es gelangt dorthin über den Trennverstärker 160 und wird geschaltet durch den Transistor 158, der während des Zeitschlitzes 1 durch das Signal AC ADDR durchgeschaltet wird. Dadurch werden die Vergleichssignale COMP OUT der Vergleichsleitungen 63 aller Wörter an die Prioritätsschaltung 148 durchgeschaltet. Diese arbeitet wie vorstehend beschrieben. Das Signal AC BUSY geht auf logisch 1 oder 0. Wenn alle Wörter einer Verbindung zugeordnet sind, dann ist AC BUSY auf logisch 1 und bleibt auch dort. Ist zuvor ein Wort frei geworden und alle Wörter wurden vorher benutzt, dann geht AC BUSY von logisch 1 auf logisch 0 zurück.

Dies ist in Figur 7 als durchgehende Linie gezeichnet. Wenn das letzte freie Wort besetzt wird, dann geht das Signal AC BUSY auf logisch 1, wie in Figur 7 gestrichelt dargestellt. Der Wechsel des logischen Pegels im Signal AC BUSY kann zu jeder Zeit während der Zeitschlitze 1 bis 12 erfolgen, da die Prioritätsschaltung 148 die Wörter nicht gleichzeitig, sondern der Reihe nach prüft. Entscheidend ist, daß beim Zeitschlitz 13 das Ergebnis feststeht.

Die Einstellbefehle (command mode) erfolgen während der Zeitschlitze 13 bis 15. Der zeitliche Ablauf ist in Figur 8 und 9 dargestellt. In dieser Zeit wird z.B. ein neues Wort besetzt, indem eine Quelladresse, eine Zieladresse und Daten eingeschrieben werden und die Zuordnungszelle auf logisch 1 gesetzt wird. Weiter kann ein Wort als frei gekennzeichnet werden oder es kann die Quell- oder Zieladresse verwendet werden, um in die anderen Teile des Wortes einzuschreiben oder daraus auszulesen.

In dieser Einstellphase werden häufig Vergleiche durchgeführt und die Signale auf den Vergleichsleitungen, D COMP OUT und S COMP OUT, gehen oft auf logisch 1. Es ist meist unerwünscht, daß dann die Speicherzellen 28 im Datenteil 24 aktiviert werden. Dies wird dadurch verhindert, daß das Signal NCH auf logisch 0 gelegt wird, wodurch die UND-Gatter 134 und 136 sperren.

Figur 8 zeigt den Ablauf solcher Befehle, bei denen von einer Zieladresse ausgegangen wird. Dann kann in den Quellangabenteil 38 und/oder den Datenteil 24 eingeschrieben oder daraus ausgelesen werden. Auch kann die Zuordnungszelle 142, die Rückstellzelle 178 und die Sperrzelle 184 auf diese Weise beeinflußt werden.

Eine Zieladresse liegt am Zieladress-Bus 52 (D ADDR BUS in Figur 8) während des Zeitschlitzes 14 an. Gleichzeitig liegt diese Adresse am Eingang der Zieladress-Steuerschaltung 50. Das Signal D C PRG führt zur Entladung der Bitleitungen und zur Vorladung der Vergleichsleitungen 62 (D COMP OUT) auf logisch 1. In der zweiten Hälfte des Zeitschlitzes 14 wird das Signal COMP D auf logisch 1 gesetzt und dadurch der Vergleich eingeleitet. Bei positivem Vergleich bleibt D COMP OUT auf logisch 1. Andernfalls geht D COMP OUT in der zweiten Hälfte von Zeitschlitz 14 auf logisch 0 zurück. Unmittelbar nach dem Vergleich wird im Zeitschlitz 15 das Signal CMD (D) an das UND-Gatter 138 angelegt. Der Ausgang des UND-Gatters 138, das die Signale CMD (D), D COMP OUT und das Taktsignal CLK auswertet, bringt dann die Wortleitung 98 (D WL2 in Figur 8) auf logisch 1. Dadurch wird das ganze Wort aktiviert. Wenn CMD (D) auf logisch 1 ist, dann wird über den Quelladress-Bus 44 (S ADDR BUS in Figur 8) dem Quellangabenteil 38 eine Quelladresse angeboten. Gleichzeitig kann der Zeitmultiplex-Datenbus 32 dem Datenteil 24 Daten anbieten. Während der zweiten Hälfte im Zeitschlitz 15 kann ein WRS-und/oder ein DWR-Signal zum Einschreiben der Quelladresse und/oder der Daten führen. Durch ein RDS-und/oder ein DRD-Signal könnten auch Quelladresse und/oder Daten ausgelesen werden. Durch die Signale WRA, WRUA und WRI kann auch in die Zuordnungszelle 142, die Rückstellzelle 178 und die Sperrzelle 184 eingeschrieben werden.

So wie von der Zieladresse ausgegangen werden kann, kann auch von der Quelladresse ausgegangen werden, um Zieladresse und/oder Daten zu lesen oder einzuschreiben und um die Zuordnungszelle, die Rückstellzelle und die Sperrzelle zu beeinflussen. Der Vorgang ist gleich wie oben beschrieben.

Anhand von Figur 9 wird nun der zeitliche Ablauf beschrieben, der sich ergibt, wenn ein neues Wort belegt wird. Dabei kann in den Quellangabenteil 38, den Zielangabenteil 48 und den Datenteil 24 eingeschrieben werden. Die Zuordnungszelle 142 wird auf logisch 1 gesetzt. Während der zwei Zeitschlitze 14 und 15 werden die Zieladresse und die Quelladresse dem Ziel- bzw. Quellangabenteil angeboten. Während der ersten Hälfte des Zeitschlitzes 14 werden die Bitleitungen durch die Signale S C PRG und D C PRG zur Entladung gebracht. Gleichzeitig werden die Vergleichsleitungen S COMP OUT und D COMP OUT auf logisch 1 vorgeladen. Unmittelbar danach werden durch COMP D und COMP S Vergleiche veranlaßt. Je nach Ergebnis des Vergleichs bleiben die Signale D COMP OUT und S COMP OUT auf logisch 1 oder gehen wieder auf logisch 0 zurück. Während des Vergleichs werden die Signale CMD (S) und CMD (D) auf logisch 0 gehalten. Damit kann das Vergleichs-Signal S COMP OUT und D COMP OUT nicht auf die Wortleitung 98 gelangen und die Speicherzellen aktivieren.

Zu Beginn der Durchschaltung von Verbindung (switch mode) im Zeitschlitz 1 wurde durch das Signal AC ADDR die Prioritätsschaltung 148 aktiviert. Wenn noch ein freies Wort vorhanden ist, dann ist AC BUSY auf logisch 0 und das UND-Gatter 164 desjenigen freien Wortes mit der höchsten Priorität erhält von der Prioritätsschaltung eine logische 1. Es wird nun angenommen, daß die gesuchten Adressen auf dem Quelladress-Buss 44 (S ADDR BUS) und dem Zieladress-Bus 52 (D ADDR BUS) nicht gefunden wurden und daß die Vergleichssignale D COMP OUT und S COMP OUT jeweils in allen Wörtern auf logisch 0 zurückgegangen sind. Damit gehen auch die Signale D BUSY und S BUSY auf logisch 0 zurück und zeigen damit an, daß die neuen Quell- und Zieladressen im Quellangaben- bzw. Zielangabenteil nicht enthalten sind. Wenn die Signale D BUSY und S BUSY auf logisch 1 bleiben, dann entfällt das nachfolgende Einschreiben.

Wenn alle vorstehend genannten Bedingungen erfüllt sind, dann geht das Signal AC im Zeitschlitz auf logisch 1. Bei demjenigen freien Wort mit der höchsten Priorität, das an seinem UND-Gatter 164 eine logische 1 von der Prioritätsschaltung 148 erhält, wird das UND-Gatter durch das Signal AC und die nächste logische 1 des Taktsignals CLK durchgeschaltet und legt die Wortleitung 98, (Signal WL2 in Figur 9) auf logisch 1 und aktiviert damit das ganze Wort. Während der zweiten Hälfte im Zeitschlitz 15 kann nun eingeschrieben werden, wenn die Signale WRS, WRD, DWR und WRA auf logisch 1 gelegt werden. Dadurch werden die Quelladresse in den Quellangabenteil 38, die Zieladresse in den Zielangabenteil 48 und die Daten in den Datenteil 24 eingeschrieben und die Zuordnungszelle 142 auf logisch 1 gesetzt. Dem gehen in der ersten Hälfte im Zeitschlitz 15 die erforderlichen Signale S W PRG, D W PRG, PRG RAM und AW PRG voraus.

Aus dem Beschriebenen ist ersichtlich, daß die Erfindung in ihrer einfachsten Form zur Bereitstellung einer Vielzahl von Durchschalteverbindungen geeignet ist. Die Erfindung gibt auch die Möglichkeit, Verbindungswege dynamisch durch Befehle auf- und abzubauen. Durch die Erfindung können Verbindungen zwischen räumlichen Ein-/Ausgängen und zeitlichen Kanälen über diese Ein-/Ausgänge hergestellt werden. Durch die Erfindung wird damit eine sehr flexible kombinierte Zeit- und Raumkoppelstufe zur Verfügung gestellt.

**Ansprüche**

1. Speicheranordnung mit einer Vielzahl unabhängig voneinander aktivierbarer Schreib-Lese-Speicherzellen (26) **dadurch gekennzeichnet,** daß jede Schreib-Lese-Speicherzelle (26) zusammen mit einem ersten, aus mehreren Assoziativspeicherzellen (40) bestehenden Assoziativspeicherteil (16, 48) und einem zweiten, aus mehreren Assoziativspeicherzellen (40) bestehenden Assoziativspeicherteil(14, 38) ein Speicherwort (12) bildet, daß jeder Assoziativspeicherteil (16 , 48; 14, 38) einen Vergleichsausgang (62, 64; 58, 60) aufweist, der die Gleichheit eines an den Assoziativspeicherteil (16, 48; 14, 38) angelegten Adress-Datenworts mit einem darin enthaltenen Datenwort anzeigt und daß jede Schreib-Lese-Speicherzelle (26) sowohl vom Vergleichsausgang (62, 64) des ersten Assoziativspeicherteils (16, 48) desselben Speicherworts (12) als auch vom Vergleichsausgang (58, 60) des zweiten Assoziativspeicherteils (14, 38) desselben Speicherworts (12) aus aktivierbar ist.

2. Speicheranordnung nach Anspruch 1, dadurch gekennzeichnet, daß jedes Speicherwort (12) weitere Schreiblese-Speicherzellen (26) aufweist und daß alle Schreib-Lese-Speicherzellen (26) als ein Datenteil (18, 24) eines Speicherworts (12) gemeinsam aktivierbar sind.

3. Speicheranordnung nach Anspruch 1 oder 2, dadurch gekennzeichnet, daß eine erste Adressierschaltung (50, 54) zum Adressieren der ersten Assoziativspeicherteile (16, 48) und eine zweite Adressierschaltung (42, 46) zum Adressieren der zweiten Assoziativspeicherteile (14, 38) vorhanden sind und daß eine Schreib-Lese-Steuerschaltung (30) vorhanden ist, die das Einschreiben in die Schreib-Lese-Speicherzellen (26) und das Auslesen daraus steuert.

4. Koppelstufe mit einer Speicheranordnung nach Anspruch 2 oder 3, **dadurch gekennzeichnet,** daß der erste Assoziativspeicherteil (16, 48) Adressen von Informationssenken (Zieladressen) und der zweite Assoziativspeicherteil (14, 38) Adressen von Informationsquellen speichert, daß ein Zeitmultiplex-Datenbus (32) vorhanden ist, über den der Datenteil (18, 24) mit den Informationsquellen und -senken (34) verbunden ist, daß jedes Speicherwort (12) einen Verbindungsweg zwischen einer Informationsquelle und einer Informationssenke herstellen kann und daß die Übermittlung einer Information von einer Quelle zu einer Senke dadurch erfolgt·daß der zweite Assoziativspeicherteil (14, 38) mit der Adresse der Quelle adressiert wird und dabei den Datenteil (18, 24) des zugehörigen Speicherworts (12) aktiviert, daß der Datenteil (18, 24) mit der adressierten Quelle verbunden wird, daß die Information von der adressierten Quelle in den Datenteil (18, 24) eines Speicherwortes (12) eingeschrieben wird , daß der erste Assoziativspeicherteil (16, 48) mit der Adresse der Senke (Zieladresse) adressiert wird und dabei den Datenteil (18, 24) des zugehörigen Speicherworts (12) aktiviert, daß der Datenteil (18, 24) mit der adressierten Senke verbunden wird und die Information vom Datenteil (18, 24) dieses Speicherworts (12) an die adressierte Senke ausgelesen wird.

5. Koppelstufe nach Anspruch 4, dadurch gekennzeichnet, daß die erste Adressierschaltung (50, 54) und die zweite Adressierschaltung (42, 46) jeweils eine Mehrzahl von Zählern und Registern zum Erzeugen und Speichern von Quell- und Zieladressen enthalten.

6. Koppelstufe nach Anspruch 4 oder 5, dadurch gekennzeichnet, daß Steuereinrichtungen (36, 39, 56) vorhanden sind, die den zeitlichen Ablauf so steuern, daß die Vorgabe von (Quell-)Adressen an den zweiten Assoziativspeicherteil (14, 38) mit der Verbindung zwischen Datenteil (18, 24) und adressierter Quelle und die Vorgabe von (Ziel-)Adressen an den ersten Assoziativspeicherteil (16, 48) mit der Verbindung zwischen Datenteil (18, 24) und adressierter Senke zeitlich zusammenpaßt.

7. Koppelstufe nach einem der Ansprüche 4, 5 oder 6, dadurch gekennzeichnet, daß Quellen und Senken physikalische Ein- und Ausgänge sind, daß die Koppelstufe als Raumkoppelstufe arbeitet und daß der Datenteil (18, 24) mit den Quellen und Senken über einen Zeitmultiplex-Datenbus (32) verbunden ist.

8. Koppelstufe nach Anspruch 7, dadurch gekennzeichnet, daß mindestens über einen Teil der Ein- und Ausgänge Zeitmultiplex-Datenkanäle laufen, wobei jeder Kanal eine Quelle bzw. Senke bildet und daß die Koppelstufe als Raum- und Zeitkoppelstufe arbeitet.

9. Koppelstufe nach einem der Ansprüche 4 bis 8 dadurch gekennzeichnet, daß Schaltungsteile (142, 144, 178, 180, 98) vorhanden sind, die es erlauben, einzelne Speicherwörter (12) für eine Verbindung zu reservieren und wieder freizugeben und die es erlauben, Quell- und Zieladressen in die beiden Assoziativspeicherteile (14, 38; 16, 48) einzuschreiben.

10. Koppelstufe nach Anspruch 9, dadurch gekennzeichnet, daß ein Schaltungsteil (148) vorhanden ist, der feststellt, ob noch ein Speicherwort (12) frei ist.

11. Koppelstufe nach Anspruch 10, dadurch gekennzeichnet, daß der Schaltungsteil (148), der feststellt, ob noch ein Speicherwort (12) frei ist, einem dieser Speicherwörter (12) die höchste Priorität zuweist und dieses Speicherwort (12) für die nächste aufzubauende Verbindung freigibt.

12. Koppelstufe nach Anspruch 11, dadurch gekennzeichnet, daß Sperreinrichtungen (184) vorhanden sind, mit denen das Einschreiben einer Information in einen Datenteil (18, 24) nach dem ersten Adressieren einer neu in den zugehörigen Assoziativspeicherteil (14, 38) eingegebenen Adresse solange gesperrt wird, bis die zu diesem Speicherwort (12) gehörige Zieladresse erstmals adressiert wurde.

13. Koppelstufe nach einem der Ansprüche 9 bis 12, dadurch gekennzeichnet, daß Schaltungsteile (190, 192) vorhanden sind, durch die verhindert werden kann, daß eine Adresse mehrmals als Quelladresse oder mehrmals als Zieladresse vorgegeben wird.

14. Koppelstufe nach einem der Ansprüche 9 bis 13, dadurch gekennzeichnet, daß Schaltungsteile (98, 183, 140) vorhanden sind, die das Auslesen von Adressen aus dem ersten und zweiten Assziativspeicherteil (16, 48; 14, 38) ermöglichen.

FIG.1

J.R.Yudichak 1-2
26. 11. 85

0 184 774

FIG.2

FIG.3

0 184 774

J.R.Yudichak 1-2
26. 11. 85

FIG.4

FIG.6

J.R.Yudichak 1-2
26. 11. 85

FIG.5

0 184 774

J.R.Yudichak 1-2
26. 11. 85

FIG.7

J.R. Yudichak 1-2
26. 11. 85

0 184 774

FIG.8

FIG.9

J.R. Yudichak 1-
26. 11. 85